# EUROPÄISCHE PATENTSCHRIFT

(11) **EP 2 875 533 B1**
(45) Veröffentlichungstag und Bekanntmachung des Hinweises auf die Patenterteilung: **30.09.2015**
(21) Anmeldenummer: 14753218.8
(22) Anmeldetag: 18.07.2014
(51) Int. Cl.: H01L 41/12, H02N 2/04

(54) **AKTUATORVORRICHTUNG MIT MAGNETISCHEM FORMGEDÄCHTNISELEMENT**
ACTUATOR DEVICE HAVING A MAGNETIC SHAPE-MEMORY ELEMENT
DISPOSITIF D'ACTIONNEMENT COMPORTANT UN ÉLÉMENT MAGNÉTIQUE À MÉMOIRE DE FORME

(30) Priorität: 17.09.2013 DE 102013110253
(43) Veröffentlichungstag der Anmeldung: 27.05.2015
(73) Patentinhaber: Eto Magnetic GmbH, 78333 Stockach (DE)
(72) Erfinder: SCHIEPP, Thomas, 78606 Seitingen-Oberflacht (DE); LAUFENBERG, Markus, 78333 Stockach (DE)
(74) Vertreter: Behrmann, Niels
(86) Internationale Anmeldenummer: PCT/EP2014/065565
(87) Internationale Veröffentlichungsnummer: WO 2015/039784

(56) Entgegenhaltungen:
- EP-B1- 1 760 796
- DE-A1-102004 060 532
- JP-A- 2001 280 215

## Beschreibung

Die vorliegende Erfindung betrifft eine Aktuatorvorrichtung nach dem Oberbegriff des Hauptanspruchs.

Eine derartige Vorrichtung ist beispielsweise aus der EP 1 760 796 B1 bekannt und beschreibt den Einsatz eines Expansionselements aus einem magnetischen Formgedächtnislegierungsmaterial (MSM = magnetic shape memory, hier im Weiteren gleichbedeutet benutzt mit magnetischer FGL = Formgedächtnislegierung) für die gewünschte Aktuator- bzw. Stellvorrichtung. Konkret wird zum Bewirken dieses Antriebs ein MSM-(FGL-) Kristallkörper, typischerweise hergestellt auf der Basis einer NiMnGa-Legierung, mit einem durch eine bestromte Spule erzeugten Magnetfeld beaufschlagt. Als Reaktion auf einen solchen (typischerweise mantelseitig eingebrachten) Magnetfluss führt der MSM-Kristallkörper als Expansionseinheit eine Expansionsbewegung durch, deren Hub üblicherweise in einer Richtung senkrecht zur Durchflutungsrichtung mit dem Magnetfluss verläuft. Diese Expansionsbewegung wirkt dann auf einen endseitig entlang der Expansions- bzw. Stellrichtung anschließenden Stößel, welcher wiederum, entsprechend einer jeweiligen Stellaufgabe, mit einem geeigneten Stellpartner zusammenwirkt.

Generell weisen Aktuatoren auf MSM-Basis den Vorteil schneller Schaltzeiten und hoher Schaltzyklen (sogenannte Schaltspielzahl, welche mehr als 400 Mio Expansionsvorgänge umfassen kann) auf. Zur Aktuatorik eingesetzte und als Reaktion auf den eingeleiteten Magnetfluss expandierbare MSM-Expansionseinheiten ermöglichen einen typischen Expansionshub in der Größenordnung von ca. 4 % bis 6 % bezogen auf die Stell- bzw. Expansionsrichtung (im nicht expandierten Zustand), wobei der üblicherweise in dieser Richtung langgestreckte Kristallkörper zur maximalen Hubausnutzung an seiner der Stößeleinheit gegenüberliegenden Stirnseite abgestützt bzw. dort fixiert ist und mantelseitig von Flussleitmitteln den Magnetfluss eingebracht erhält.

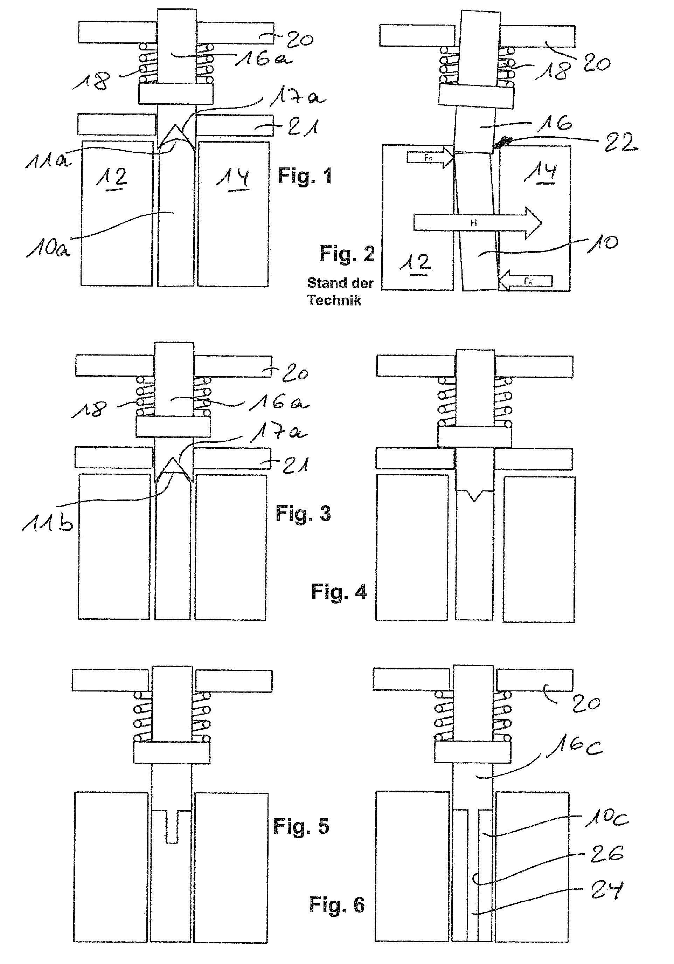

Die Fig. 2 zum schematisch dargestellten, als bekannt vorausgesetzten Stand der Technik verdeutlicht eine auf diesem Wirkungsprinzip resultierende Problematik: Ein MSM-Kristalkörper 10 als Expansionseinheit, geeignet bodenseitig abgestützt, wird über ein Paar mantelseitig angreifender Flussleitkörper 12, 14 mit einem (in der Figurenebene quer und damit senkrecht zur Längsachse verlaufenden) Magnetfluss H zur Expansion beaufschlagt. Da in der Praxis nur selten ein vollständig homogener magnetischer Flusseintrag in den Expansionskörper 12 möglich ist und dieser, um eine effiziente Expansion zu ermöglichen, spielbehaftet innerhalb der Flussleitstruktur 12, 14 geführt sein muss, kommt es zu einer Schräglage bzw. einem Verkippen des Expansionskristalls 10, wie schematisch in der Fig. 2 gezeigt. Die Konsequenz sind nachteilige Reibkräfte F_{R} an den durch die Schräglage entstehenden Kontaktflächen zu den Flussleitelementen 12, 14, mit der Folge, dass Reibung die dynamischen Eigenschaften sowie die Effizienz der Aktuatorvorrichtung nachträglich beeinflusst und zusätzlich Verschleiß- bzw. sogenannte Tribokorrosion speziell an den Enden des Expansionskörpers entsteht. Möglich sind sogar (lokale) Deformationseffekte auf das MSM-Element, mit der nachteiligen Konsequenz, dass das Betriebsverhalten bzw. die Lebensdauer der Vorrichtung beeinträchtigt ist.

Zusätzlich nachteilig greift die eingriffsseitige (d.h. auf eine zusammenwirkende Stößeleinheit 16, welche schematisch gezeigt gegen die Kraft einer Rückstellfeder 18 in einem Aktuatorgehäuse 20 geführt ist) gerichtete Stirnfläche im Übergangsbereich 22 zum Stößel 16 exzentrisch und damit punktuell auf den Stößel auf, schafft hier potentiell schädliche Reibung und führt zudem zu einem (typischerweise entgegengerichteten) Verkippen der Stößeleinheit 16 innerhalb seiner (d.h. der dem Stößel zugeordneten) Führung. Bei auch hier notwendig vorhandenem Spiel wirkt sich somit das nachteilige Verkippen der Expansionseinheit aus der idealen Stellrichtung nachteilig auf die nachgeschaltete Stößeleinheit aus.

Ein weiterer nachteiliger Effekt der in Fig. 2 gezeigten, bei Einleitung des Magnetflusses H entstehenden Schräglage ist der Umstand, dass das Magnetfeld (mit angenommenem, ideal-parallel verlaufenden Flusslinien) nicht mehr senkrecht auf die entsprechende, zugehörige Seitenfläche der MSM-Expansionseinheit 10 trifft, dessen kristalline Hauptachsen jedoch parallel zu den Kanten bzw. Seitenflächen geführt sind. Entsprechend entsteht eine Winkelabweichung des Magnetfeldes von der (idealen) Normalen, was im Ergebnis zu einer Erhöhung des für den Magnetfluss benötigten Stroms führt, um eine Aktuatorbewegung (Schalten) des Aktuators zu bewirken. Auch wirkt sich nachteilig und stromerhöhend der Effekt aus, dass die gezeigte Schrägstellung einen schrägen Feldlinienverlauf (nämlich in der Figurenebene der Fig. 2 von links oben nach rechts unten) und damit einen Feldanteil in schräger Richtung begünstigt, da der magnetische Widerstand an den Reibungs- bzw. Kontaktstellen abgesenkt wird und so der Luftspalt zwischen Expansionseinheit und umgebender Flussleitstruktur überbrückt wird.

Bei der in der EP 1 760 796 B1 beschriebenen technischen Lehre wird die MSM-Expansionseinheit in einer (typischerweise mittels einer Nut realisierten) Seitenführung geführt, wobei die Nut in einer neutralen, sich geometrisch nicht verändernden Ebene liegt. Diese technische Maßnahme verhindert oder erschwert zwar das vorbeschriebene nachteilige Verkippen, ist jedoch selbst wiederum nachteilig: Zwar wird im Fall optimaler Dimensionierung und bestmöglicher Toleranzgestaltung die MSM-Einheit in ihrer durch die Nut definierten Lage gehalten, jedoch wird Reibung zwischen der Expansionseinheit und den mit dieser zusammenwirkenden Flussleitmitteln nicht verhindert, vielmehr wird diese Reibung auf den Nutbereich der MSM-Expansionseinheit verlagert. Somit steht zu erwarten, dass hier Verschleiß auftritt, welcher wiederum, gerade kritisch bei dieser relativ filigranen mechanischen Ausgestaltung, die Lebensdauer signifikant verkürzt. Auch ist die in der EP 1 760 796 B1 beschriebene Technologie toleranzanfällig, da zum Verhindern von Verkanten od.dgl. Blockierverhalten die Form und Lage der Nuten (im Zusammenwirken mit dem äußeren Führungspartner) präzise gefertigt werden muss.

Schließlich ist diese bekannte technische Lehre im Hinblick auf den Effekt nachteilig, dass, je nach Mikrostruktur des die Expansionseinheit realisierenden MSM-Körpers, beim Schaltvorgang ein Knick von ca. 3° das Element durchläuft; bereits dieser Effekt macht eine geometrisch fixe, "neutrale" Lagerung gemäß EP 1 760 796 B1 impraktikabel.

Sowohl aus der JP 2001-280215, als auch aus der DE 10 2004 060 532 A1 sind weitere Aktorvorrichtungen mit Expansionseinheiten bekannt, die auf magnetischen Formgedächtnis-Legierungsmaterialien beruhen.

Aufgabe der vorliegenden Erfindung ist es daher, eine gattungsbildende Aktuatorvorrichtung nach dem Oberbegriff des Hauptanspruchs im Hinblick auf ihr Expansions- und Effizienzverhalten zu verbessern, insbesondere eine bei der Expansionsbewegung der Expansionseinheit bewirkte Reibung an zugeordneten seitlichen Flussleitmitteln und/oder der Stößeleinheit zu vermeiden oder zu verringern, entsprechenden Verschleiß zu vermeiden oder zu verringern und so eine Vorrichtung zu schaffen, welche verbesserte Dynamik- und Stelleigenschaften kombiniert mit erhöhter Lebensdauer, vermindertem Stromverbrauch und erhöhten Schaltspielzahlen.

Die Aufgabe wird durch die Aktuatorvorrichtung mit den Merkmalen des Hauptanspruchs gelöst; vorteilhafte Weiterbildungen der Erfindung sind in den Unteransprüchen beschrieben. Schutz im Rahmen der vorliegenden Erfindung wird ferner beansprucht für die Weiterbildung des Anspruchs 7, welche gleichermaßen unabhängig Schutz entfalten soll, sowie für die Variante des unabhängigen Anspruchs 8. Schutz im Rahmen der vorliegenden Erfindung ist ferner beabsichtigt für eine MSM-Expansionseinheit zur Verwendung in den erfindungsgemäßen Aktuatorvorrichtungen, insbesondere wenn sie das Ergebnis eines Herstellungsverfahrens ist, welches nach den Schritten der Kristallherstellung, der Kristallteilung (und ggf. der vorgeschalteten Kristallvermessung zur Identifikation der Expansionsachse (n)) das Ausbilden einer profilierten Stirnseite oder Stirnfläche vorsieht, wie sie die erfindungsgemäße Funktionalität ermöglicht und beim Herstellen durch Elektropolieren und/oder Herausziehen aus einem Elektrolytbad entsteht.

In erfindungsgemäß vorteilhafter Weise ist der Übergangsbereich zwischen der Expansionseinheit und der Stößeleinheit durch geeignet profilierte Ausgestaltung der jeweiligen Endabschnitte so gebildet, dass entlang der Längsachse in den Übergangsbereich eine einen Form- und/oder Kraftschluss (quer zur Längsachse) bewirkende Überlappung entsteht; auf diese Weise kann zumindest während des Eingriffs zwischen den Einheiten, also während des Ausübens der Stellkraft durch die Expansionseinheit auf die Stößeleinheit, ein Aufrichtemoment durch die Stößeleinheit auf die MSM-Expansionseinheit übertragen werden, mit der Wirkung, dass trotz des eingetragenen Magnetflusses in den MSM-Kristall dieser in oder nahe seiner idealen Bewegungsrichtung verbleibt und dementsprechend die aus der unerwünschten Neigung resultierende schädlichen Reib-, Magnetfeldkonzentrations- und Verschleißeffekte wirksam verhindert werden können. Vielmehr sorgt die zumindest in diesem Eingriffszustand bestehende, quer zur Bewegungslängsachse wirkende Verbindung zwischen den Einheiten dafür, dass die Führung (bzw. seitliche Abstützung) der Stößeleinheit, welche weiterbildungsgemäß und bevorzugt im Rahmen der Erfindung an mehreren Stellen bzw. durchgängig entlang dessen Längserstreckung am bzw. im zugehörigen Gehäuseabschnitt realisiert ist, übertragen wird auf die MSM-Expansionseinheit und diese am Verkippen hindert.

Im Rahmen der Erfindung liegt es dabei einerseits, diesen vorteilhaften Formschluss und/oder (in der Querrichtung wirkenden) Kraftschluss sowohl lediglich temporär auszugestalten, also diesen bei voneinander gelösten bzw. lösbaren Einheiten lediglich für den Zustand vorzusehen, bei welchem durch Expansion der Expansionseinheit die Stößeleinheit angetrieben wird. Andererseits ist es weiterbildungsgemäß vorgesehen und von der Erfindung umfasst, eine unlösbare Verbindung zwischen der Expansionseinheit und der Stößeleinheit vorzusehen, so dass die erfindungsgemäße, ein Auslenken bzw. Kippen der Stößeleinheit verhindernde Führung im zugehörigen Gehäuseabschnitt permanent auf die Expansionseinheit übertragen wird und diese entlang der (idealen) Längsachse fixiert, mithin das nachteilige Verkippen wirksam verhindert.

Die erfindungsgemäße Profilierung, welche den erfindungsgemäßen Form- bzw. Kraftschluss gestattet, kann auf verschiedene Weisen realisiert sein. So ist es einerseits vorteilhaft und von Weiterbildungen der Erfindung umfasst, den auf die Stößeleinheit gerichteten Endabschnitt der Expansionseinheit im Übergangsbereich keil- oder konusförmig auszugestalten, alternativ konkav, flachkuppel- oder kalottenartig gewölbt zu bilden, wobei dann vorteilhaft der jeweils gegenüberliegende, zusammenwirkende Endabschnitt der Stößeleinheit einen zumindest den quer verlaufenden Kraftschluss ermöglichenden Innenkonus, eine Trichter- oder Kalottenform aufweist. Dieser Übergang muss damit nicht in jedem Fall formschlüssig sein, kann insbesondere auch dann noch Spiel aufnehmend ausgestaltet sein oder (deutlich verringert) Neigewinkel ermöglichen.

Insbesondere im Hinblick auf einen vorteilhaften Formschluss im Übergangsbereich zwischen den Einheiten ist es in anderen bevorzugten Ausführungsformen der Erfindung vorgesehen, eine Nut-Feder-Realisierung vorzusehen, wiederum alternativ einem der Partner endseitig einen kegel-, kegelabschnitts- oder zylinderförmigen Vorsprung zuzuordnen, welcher dann in einer jeweils geeigneten Aufnahme des Gegenpartners aufgenommen wird. Auf diese Weise sorgt dann der erreichbare Formschluss für einen besonders stabilen Übergang und damit für eine besonders wirksame Übertragung der die Kippneigung der Expansionseinheit verhindernden Führungskraft durch die Stößeleinheit. In fertigungstechnisch besonders günstiger Weise und bei Ausgestaltung des Vorsprungs als (bevorzugt zentrischer) Zylinder ist es wiederum bevorzugt, die zugehörige Aufnahme als Bohrung od.dgl. (weiter bevorzugt durchgehende) Öffnung vorzusehen, wobei aus Gründen der einfacheren Fertigbarkeit dies bevorzugt in der Expansionseinheit ausgeführt wird, die erfinderische Weiterbildung jedoch nicht auf diese Variante beschränkt ist.

Im Rahmen weiterer bevorzugter Weiterbildungen der Erfindung liegt es, den Übergangsbereich zwischen Expansions- und Stößeleinheit nicht unmittelbar, sondern unter Zwischen- bzw. Nebenschaltung eines weiterbildungsgemäß vorgesehenen Verbindungselements durchzuführen. Dies würde bevorzugt an einem der Partner, weiter bevorzugt unlösbar, vorgesehen sein und dann, zum Zweck der erfindungsgemäßen Übertragung der Aufrichtekraft, einen geeigneten Aufnahmeabschnitt, weiter bevorzugt als Hülse bzw. Hülsensegment ausgestaltet, anbieten.

Eine derartige Weiterbildung der Erfindung gestattet es vorteilhaft, die Fertigung der Stößel- bzw. Expansionseinheit einfacher zu gestalten, insbesondere eine Bearbeitung des (potentiell spröden und mechanisch schwierig handzuhabenden) Eingriffsendes der Expansionseinheit im Übergangsbereich dadurch zu verhindern, dass dieses (in idealer zylindrischer bzw. quaderförmiger Kontur) in den vom Verbindungselement angebotenen Aufnahmeabschnitt zum Herstellen des erfindungsgemäßen Übergangs eingreift.

Um die Magnetflussverhältnisse im Übergangsbereich, insbesondere bei Einsatz eines derartigen Verbindungselements, anzupassen bzw. zu optimieren, ist es wiederum im Rahmen vorteilhafter Weiterbildungen der Erfindung vorgesehen, eine Längsschnittskontur benachbarter Flussleitabschnitte geeignet anzupassen (z.B. auszuformen), ergänzend oder alternativ könnte der Magnetflusseintrag mittels der Flussleitabschnitte in die MSM-Expansionseinheit unter Auslassung dieses Verbindungselements erfolgen (bzw. dieses, wiederum alternativ, geeignet magnetisch flussleitend ausgebildet sein).

Die Erfindungsvariante, den Übergangsbereich zwischen der Expansionseinheit und der Stößeleinheit fest (insbesondere kippfest) und unlösbar auszugestalten, sieht prinzipiell beliebige Verbindungstechniken vor, wobei das Kleben, Löten oder (Ver-)Schweißen dieser Einheiten bevorzugte Varianten sind. Dabei ist es einerseits von der Erfindung umfasst, in der Weiterbildung des Erfindungsgedankens der profilierten Ausgestaltung des Übergangsbereichs diese (entsprechend profilierten) Enden der Einheiten miteinander unlösbar zu verbinden. Alternativ (und unabhängig im Rahmen der Erfindung beansprucht) ist es gleichwohl auch vorgesehen, geeignet parallele bzw. plane Endflächen von Expansions- bzw. Stößeleinheit, welche ohne unlösbare Verbindung zunächst keine Querkraft im Übergang übertragen könnten, auf diese weiterbildungsgemäße Weise unlösbar und damit zum Erreichen der erfindungsgemäßen Vorteile zu verbinden.

Wiederum unabhängiger Schutz im Rahmen der Erfindung, gleichwohl auch als mögliche Weiterbildung der vorgelagerten Patentansprüche, ist vorgesehen, der Expansionseinheit mantel- bzw. (gegenüberliegend der Stößeleinheit) endseitig Stütz- und/oder Aufrichtemittel zuzuordnen. Diese Stütz- bzw. Aufrichtemittel, etwa in einem End-Stützbereich zu einem bodenseitigen Aktuatorgehäuse vorgesehene und geeignet mit der Stößeleinheit zusammenwirkende Profilierungen, bewirken dann zumindest im Expansions- und Kraftbeaufschlagungsbetrieb auf die Stößeleinheit ein Aufrichten der Expansionseinheit in die ideale, verkippungsfreie Längsachse. Eine vergleichbare Wirkung erreichen die ergänzend oder alternativ vorsehbaren mantelseitigen Stütz- bzw. Aufrichtemittel, welche, geeignet als Puffer-, Walk- oder Federmittel, mantelseitig angreifen und die Expansionseinheit in Richtung auf die ideale Längsachse abstützen (wobei sowohl metallische oder polymere) Federmittel, als auch andere Elastomerkörper, auch punktuell angreifend, diese vorteilhafte Wirkung realisieren können, so dass auch etwa Schäume od.dgl. zu diesen weiterbildungsgemäß vorteilhaften Instrumenten zu zählen sind. Wiederum vorteilhaft weiterbildend ist es vorgesehen, dass diese Puffer-, Walk- und Federmittel, in beliebigen Ausgestaltungen, magnetisch leitend realisiert sind, was den mantelseitigen Flusseintrag in die MSM-Expansionseinheit erleichtert und optimiert (da ja insoweit die Expansionseinheit dann mantelseitig gegen die Flussleitmittel abzustützen wäre und ein zu großer Luftspalt hier den Flusseintrag und damit die Effizienz der Gesamtvorrichtung nachteilig beeinträchtigen würde).

Im Ergebnis wird durch die vorliegende Erfindung in überraschend einfacher, eleganter und herstellungstechnisch günstiger Weise die praktisch bedeutsame Aufgabe gelöst, eine (notwendigerweise spielbehaftet) in einer seitlichen bzw. mantelseitigen Flussleitanordnung gehaltene MSM-Expansionseinheit von einem Verkippen aus ihrer Expansions- und Längsrichtung zu bewahren, indem nämlich auf verschiedene Weisen die durch die Stößeleinheit als Partner bereitgestellte Führung auf die Expansionseinheit am Übergangsbereich übertragen wird und auf diese Weise die gewünschte Stabilisierung einfach und mit geringem Aufwand ermöglicht ist. Geeignet mantel- oder gegenüberliegend stirnseitig angreifende Maßnahmen sind vorteilhafte Varianten bzw. alternative Realisierungsformen, welche je nach Einsatzzweck dann geeignet gewählt werden können. Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in
- Fig. 1:: eine Prinzipdarstellung im Längsschnitt einer ersten Ausführungsform der vorliegenden Erfindung;
- Fig. 2:: eine Darstellung in der Perspektive analog zur Fig. 1 zum Verdeutlichen der Ausgangslage aus dem Stand der Technik und der damit verbundenen Nachteile;
- Fig. 3:: eine Variante zur Fig. 1 als zweites Ausführungsbeispiel;
- Fig. 4:: eine Variante zur Fig. 1 als drittes Ausführungsbeispiel;
- Fig. 5, 6:: Varianten zu den zuvor beschriebenen Ausführungsbeispielen als viertes Ausführungsbeispiel;
- Fig. 7:: eine fünfte Ausführungsform der vorliegenden Erfindung;
- Fig. 8:: eine sechste Ausführungsform der vorliegenden Erfindung;
- Fig. 9:: eine siebte Ausführungsform der vorliegenden Erfindung;
- Fig. 10.: eine achte Ausführungsform der vorliegenden Erfindung und
- Fig. 11:: eine neunte Ausführungsform der vorliegenden Erfindung.

Bei allen nachfolgend zu beschreibenden Ausführungsbeispielen bedeuten gleiche Bezugszeichen identische bzw. funktional-äquivalente Funktionskomponenten, so dass selbst bei nicht für jedes Ausführungsbeispiel im Detail beschriebener Einzelkomponente diese als gleichwirkend bzw. analog zu vorbeschriebenen Ausführungsbeispielen bzw. dem Stand der Technik zu verstehen ist. Auch wurde zur Vereinfachung bei der Illustration der Erfindungsvarianten eine gleichbleibende, identische Längsschnitt-Darstellung gewählt; der Fachmann versteht, dass hier jeweils beliebige, auch nicht-radialsymmetrische Varianten denkbar sind.

Die Fig. 1, im Hinblick auf äquivalente Bezugszeichen sei insoweit auf die einleitende Beschreibung zum gewählten Stand der Technik gemäß Fig. 2 verwiesen, verdeutlicht zunächst, wie durch im Übergangsbereich 22 profiliert ausgestaltete, jeweilige Endabschnitte der MSM-Expansionseinheit 10 bzw. der Stößeleinheit 16 der erfindungsgemäße, quer zur Längs-/Erstreckungsrichtung wirkende Kraftschluss entsteht: Die in Fig. 1 gezeigte Expansionseinheit 10a (wiederum bodenseitig, d.h. in der Figurenebene abwärts abgestützt) bildet im Übergangsbereich 22 zur Stößeleinheit 16a eine Kalottenform bzw. einen im Längsschnitt gekrümmten Endbereich 11a aus, welcher in der gezeigten Weise in einen hohlkegelförmigen Endabschnitt 17a der Stößeleinheit 16a eingreift. Zusätzlich zeigt die Fig.1, dass die Stößeleinheit 16a nicht, wie im Stand der Technik, lediglich einends bzw. endseitig (dort in der Fig. 2 am Gehäuse 20) abgestützt ist, sondern, den Flussleitabschnitten 10, 12 axial benachbart, eine zweite Abstützung 21 in Form einer (festen) Gehäusestrebe od.dgl. mit einem das Eingriffsende 17a der Stößeleinheit 16a führenden Durchbruch aufweist.

Es wird unmittelbar deutlich, dass im Expansionsbetrieb der Expansionseinheit 10a der Fig. 1 eine wirksame Übertragung der Seitenführung der Stößeleinheit 16a auf die Stößeleinheit 10a erfolgen kann, mithin diese das in Fig. 2 zum Stand der Technik diskutierte negative Verkippen nicht mehr zeigt bzw. nur noch in deutlich geringerer Weise zeigen wird.

Das Ausführungsbeispiel der Fig. 3 zeigt als Variante zur Fig. 1 eine alternative Ausgestaltung des Eingriffsbereichs am MSM-Expansionskörper. Diese Expansionseinheit 10b in Fig. 3 weist nunmehr einen kegelstumpfförmigen Abschnitt 11 b auf, welcher, mit verbessertem Formschluss, in den Hohlkegel 17a am eingriffsseitigen Ende der Stößeleinheit 16a eingreifen kann. Wiederum realisiert das Ausführungsbeispiel der Fig. 3 vorteilhaft die Übertragung eines Aufricht- bzw. Quer-Führungsmoments auf die Expansionseinheit 10b.

Die Ausführungsbeispiele der Fig. 4 bis 6 zeigen weitere Varianten, hier zur Realisierung eines Formschlusses zwischen Stößeleinheit und MSM-Expansionseinheit im Übergangsbereich. So verdeutlicht die Fig. 4 entweder eine quer verlaufende Nut-Feder-Kombination mit spitzem Zulauf (Fig. 5 dagegen eine entsprechende Nut-Feder-Konfiguration mit querschnittlich rechteckförmigem Verlauf); alternativ und wiederum in radial symmetrischer Betrachtung würden die Varianten der Fig. 4 bzw. 5 auch kegel-(Fig. 4) bzw. zylinderförmige (Fig. 5) Vorsprünge offenbaren, welche axialmittig in jeweils zugehörige, passend ausgestaltete Ausnehmungen (mittig-hohlkeglig in Fig. 4, hohlzylindrisch in Fig. 5) eingreifen. Die Fig. 6 offenbart wiederum eine Variante, bei welcher im Übergangsbereich zwischen dem MSM-Expansionskörper 10c und der Stößeleinheit 16c der Formschluss sowie (quer wirkende) Kraftschluss realisiert wird durch einen Durchmesser gegenüber dem oberen Stößel verringerten Eingriffsstößel-Ansatz als langgestreckten Vorsprung 24 am Stößel, welcher eingreift in eine zentrische Bohrung 26 als Durchbruch im MSM-Kristallkörper und so eine einfach herzustellende, gleichwohl hochbelastbare (und in Grenzen zudem flexible) Verbindung ermöglicht.

Allen vorgenannten Ausführungsbeispielen ist gemein, dass diese auch im Hinblick auf die jeweils gezeigten Profilierungen invertiert werden können, also etwa die im Zusammenhang mit der eingriffsseitigen Stößelausgestaltung gezeigten Vorsprünge gleichermaßen als MSM-kristallseitige Vorsprünge realisiert sein könnten und in entsprechend negative Aus- bzw. Einformungen der Stößeleinheit dann eingreifen können.

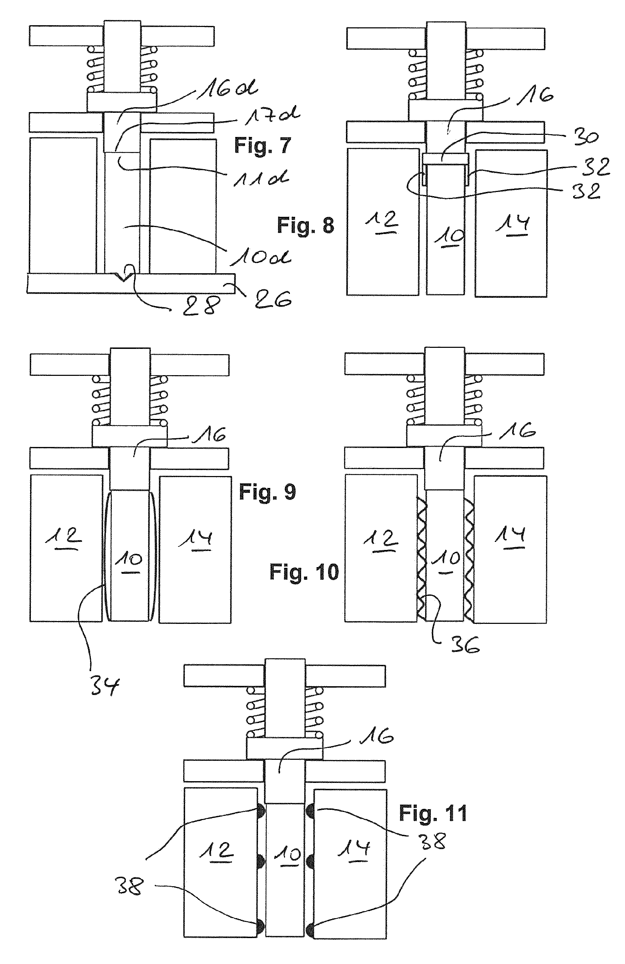

Die Fig. 7 zeigt als Ausführungsbeispiel der Erfindung eine Variante, bei welcher eine Stößeleinheit 16d mit einer plan verlaufenden Querfläche 17d fest und unlösbar aufsitzt auf einer entsprechend planen und parallel verlaufenden Stirnfläche 11 d der zugeordneten MSM-Expansionseinheit 10d. Diese ist zudem bodenseitig (d.h. im Hinblick auf einen bodenseitigen Gehäuseabschnitt 26) profiliert abgestützt mittels eines Profilübergangs 28, welcher im gezeigten Ausführungsbeispiel eine (zumindest bei Expansion bzw. Kraftbelastung in axialer Längsrichtung bewirkte) Ausrichtung auf die Längsachse erreicht; je nach Ausgestaltung des Übergangs zum Bodenabschnitt 28 (welcher prinzipiell auch unprofiliert, d.h. jeweils plan sein kann), ist es zudem alternativ möglich, den Übergangsbereich zwischen dem planen MSM-Kristallabschnitt 11d und dem Stößelabschnitt 17d ohne feste Verbindung auszugestalten, damit diese Einheiten lösbar aufeinander bzw. miteinander zusammenwirkend vorzusehen.

Das Ausführungsbeispiel der Fig. 8 verdeutlicht ein weiteres Ausführungsbeispiel der Erfindung, wobei hier die Stößeleinheit 16 bzw. die Expansionseinheit 10 in ihrer unprofilierten Form verbleiben können und der erfindungsgemäß vorteilhafte, das Verkippen der Expansionseinheit verhindernde Effekt durch ein Verbindungselement 30 realisiert ist, welches im gezeigten Ausführungsbeispiel (z.B. durch Verkleben) unlösbar stirnseitig auf der Stößeleinheit aufsitzt und, in der Längsschnittsansicht der Fig. 8 durch ein Paar von Längsstegen 32 verdeutlicht, eine Aufnahme für das übergangsseitige Ende der MSM-Expansionseinheit 10 anbietet. Alternativ ist dieses Element als Baugruppenabschnitt der Stößeleinheit 16, einstückig an dieser ansitzend, realisiert. Auf diese Weise kann vorteilhaft insbesondere eine spanende oder auf andere Weise profilgebende Behandlung des übergangsseitigen Endabschnitts der Einheiten (insbesondere der Expansionseinheit) vermieden werden. Weiterbildungsgemäß ist es zudem möglich und vorteilhaft, die seitlich ausgebildeten Flussleitabschnitte 12, 14 geeignet anzupassen, etwa dadurch, dass entweder diese Einheiten in axialer (Erstreckungs-) Richtung seitlich sich nicht über die Baugruppe 32 erstrecken, alternativ in diesem Bereich geeignete Ein- bzw. Ausformungen aufweisen (wobei etwa dann auch die Verbindungsbaugruppe 32 geeignet magnetisch leitend ausgestaltet sein kann), so dass insoweit entlang der gesamten Eintragslänge in die MSM-Expansionseinheit ein homogener Magnetflusseintrag ermöglicht ist.

Die Fig. 9 bis 11 verdeutlichen Varianten der Erfindung, bei welchen durch seitlich an die MSM-Expansionseinheit 10 angreifende Mittel diese abgestützt und am nachteiligen Verkippen (Fig. 2) gehindert werden; diese Varianten sind als isolierte Realisierungsformen der Erfindung genauso möglich, wie als vorteilhafte Weiterbildungen der vorbeschriebenen Erfindungsvarianten bzw. Ausführungsbeispiele. So zeigt die Fig. 9 eine mantelseitig die Expansionseinheit zu den Flussleiteinheiten 12, 14 abstützende Feder 34, welche geeignet etwa aus Federstahl oder Berylliumkupfer realisiert sein kann. Eine Variante der Federform der Fig. 9 zeigt das Ausführungsbeispiel der Fig. 10 mit einer alternativen, querschnittlich gewellt ausgestalteten Federkontur 36. Wiederum alternativ verdeutlicht das Ausführungsbeispiel der Fig. 12 bevorzugt magnetisch leitend realisierte Elastomere 38, welche, geeignet entlang der Erstreckungslänge sowie im Umfang bzw. zu den mantelseitig gegenüberliegenden Flussleitbaugruppen 12, 14 verteilt, die erfindungsgemäße Stützwirkung realisieren (bei allen diesen Ausführungsbeispielen ist prinzipiell eine lose Verkopplung von Expansionseinheit 10 und Stößeleinheit 16 ermöglicht, genauso wie die Variante der festen, unlösbaren Verbindung durch Verkleben, Verschweißen od.dgl. denkbar ist). Wiederum vorteilhafte (und in den Figuren nicht separat illustrierte) Weiterbildungen sehen etwa vor, dass die elastomeren Abstützelemente (etwa 38 in Fig. 12) so ausgestaltet sind, dass diese eine (durch eine lokale Dehnung od.dgl. Formelement des MSM-Elements 10 bewirkte) Walkbewegung aufnehmen können. Denkbar sind zudem schaumartige Materialien (weiterbildungsgemäß wiederum geeignet magnetisch leitend ausgestaltet), welche lokale Relativbewegung geeignet gepuffert und/oder walkend aufnehmen können.

Die vorliegende Erfindung ist nicht auf diese Ausführungsformen der Erfindung beschränkt, vielmehr bieten sich im Rahmen des durch die Ansprüche definierten Schutzbereichs nahezu beliebige Wege an, entsprechend einer jeweiligen Einsatzumgebung, einer notwendigen Geometrie od.dgl. das erfindungsgemäße Abstützen bzw. die Übertragung der Querabstützung der Stößeleinheit auf die Expansionseinheit durch Kraftübertragung am Übergangsbereich zu bewirken.

## Patentansprüche

1. Aktuatorvorrichtung mit
einer ein magnetisches Formgedächtnislegierungsmaterial (MSM) aufweisenden, zum Zusammenwirken mit einer bevorzugt unmagnetischen Stößeleinheit (16; 16a bis 16d) ausgebildeten und als Reaktion auf einem eingeleiteten Magnetfluss eine Expansionsbewegung entlang einer Stellrichtung ausführenden Expansionseinheit (10; 10a bis 10d),
die entlang einer durch die Expansionsrichtung bestimmten Längsachse auf die Stößeleinheit ausgerichtet und zum Ausüben einer Stellkraft auf diese vorgesehen ist,
wobei die Stößeleinheit in einem zugeordneten Gehäuseabschnitt (21) der Aktuatoreneinheit mantelseitig geführt ist **dadurch gekennzeichnet, dass**
ein in einem Übergangsbereich zwischen der Expansionseinheit und der Stößeleinheit realisierter Endabschnitt (11a bis 11 d) der Expansionseinheit und/oder Endabschnitt (17a bis 17d) der Stößeleinheit so ausgebildet ist, dass zumindestens bei dem Ausüben der Stellkraft entlang der Längsachse im Übergangsbereich eine einen Form- und/oder Kraftschluss quer zur Längsachse bewirkende Überlappung entsteht.

2. Vorrichtung nach Anspruch 1, **dadurch gekennzeichnet, dass** der Endabschnitt der Expansionseinheit keil- oder konusartig zulaufend oder konkav, flachkuppel- oder kalottenartig gewölbt und zum Zusammenwirken mit dem einen Innenkonus, die Keil-, Trichter-, Kuppel- oder Kalottenform, insbesondere Kugelkalottenform, aufweisenden Endabschnitt der Stößeleinheit ausgebildet ist.

3. Vorrichtung nach Anspruch 1 oder 2, **dadurch gekennzeichnet, dass** im Übergangsbereich eine Nut-Feder-Verbindung und/oder eine formschlüssige Verbindung zwischen der Expansionseinheit und der Stößeleinheit realisiert ist, die für einen der Verbindungspartner einen insbesondere kegel-, kegelabschnitts- oder zylinderförmigen Vorsprung und für den anderen der Verbindungspartner eine entsprechend formschlüssig ausgebildete Vertiefung vorsieht.

4. Vorrichtung nach Anspruch 3, **dadurch gekennzeichnet, dass** die Vertiefung (26) als Durchbruch oder Längsbohrung, insbesondere in der Expansionseinheit, ausgebildet ist.

5. Vorrichtung nach einem der Ansprüche 1 bis 4, **dadurch gekennzeichnet, dass** der Übergangsbereich ein die Überlappung realisierendes, am Endbereich der Expansionseinheit oder der Stößeleinheit bevorzugt unlösbar festgelegtes oder mit der oder mit der Stößeleinheit einstückig verbundenes Verbindungselement (30) aufweist, welches einen den Endbereich der jeweils anderen Einheit zumindest teilweise umschließenden Aufnahmeabschnitt (32), insbesondere Hülsenabschnitt, anbietet.

6. Vorrichtung nach Anspruch 5, **dadurch gekennzeichnet, dass** ein zur Magnetflusseinleitung in die Expansionseinheit dieser benachbart vorgesehener Flussleitabschnitt längsschnittlich eine an eine Längsschnittkontur des Verbindungselements und/oder des Aufnahmeabschnitts angepasste Form aufweist oder axial um eine axiale Erstreckung des Verbindungselements oder des Aufnahmeabschnitts verkürzt ist.

7. Aktuatorvorrichtung, insbesondere Aktuatorvorrichtung nach einem der Ansprüche 1 bis 6, mit
einer ein magnetisches Formgedächtnislegierungsmaterial (MSM) aufweisenden, zum Zusammenwirken mit einer bevorzugt unmagnetischen Stößeleinheit ausgebildeten und als Reaktion auf einen eingeleiteten Magnetfluss eine Expansionsbewegung entlang einer Stellrichtung ausführenden Expansionseinheit, die entlang einer durch die Expansionsrichtung bestimmten Längsachse auf die Stößeleinheit ausgerichtet und zum Ausüben einer Stellkraft auf diese vorgesehen ist, wobei die Stößeleinheit in einem zugeordneten Gehäuseabschnitt der Aktuatorvorrichtung mantelseitig geführt ist,
**dadurch gekennzeichnet, dass**
in einem Übergangsbereich zwischen der Expansionseinheit und der Stößeleinheit die Einheiten unlösbar, insbesondere durch eine Klebe-, Löt- oder Schweißverbindung, miteinander verbunden sind.

8. Aktuatorvorrichtung mit
einer ein magnetisches Formgedächtnislegierungsmaterial (MSM) aufweisenden, zum Zusammenwirken mit einer bevorzugt unmagnetischen Stößeleinheit ausgebildeten und als Reaktion auf einen eingeleiteten Magnetfluss eine Expansionsbewegung entlang einer Stellrichtung ausführenden Expansionseinheit,
die entlang einer durch die Stellrichtung bestimmten Längsachse auf die Stößeleinheit ausgerichtet und zum Ausüben einer Stellkraft auf diese vorgesehen ist,
wobei die Stößeleinheit in einem zugeordneten Gehäuseabschnitt der Aktuatorvorrichtung mantelseitig geführt ist,
**dadurch gekennzeichnet,**
**dass** die in einem MSM-Gehäuseabschnitt der Aktuatorvorrichtung gehaltene Expansionseinheit mantelseitig und/oder an einer einem Übergangsbereich zur Stößeleinheit axial gegenüberliegenden Stirnseite Stütz- und/oder Aufrichtemittel (28; 34; 36) so zugeordnet aufweist, dass insbesondere bei dem Ausüben der Stellkraft durch die Expansionseinheit auf diese ein Aufrichtemoment in die Längsachse ausgeübt wird.

9. Vorrichtung nach Anspruch 8, **dadurch gekennzeichnet, dass** die Stütz- bzw. Aufrichtemittel mantelseitig an die Expansionseinheit angreifende und diese von einem umgebenden Gehäuseabschnitt abstützende Puffer-, Walk- und/oder Federmittel aufweisen.

10. Vorrichtung nach Anspruch 9, **dadurch gekennzeichnet, dass** die Puffer-, Walk- bzw. Federmittel magnetisch flussleitend ausgebildet und die Einleitung des Magnetflusses vom umgebenden Gehäuseabschnitt in die Expansionseinheit ermöglichen.

11. Vorrichtung nach einem der Ansprüche 1 bis 10, **dadurch gekennzeichnet, dass** die Stütz- bzw. Aufrichtemittel einen mit der profiliert ausgebildeten Stirnseite zusammenwirkenden, bevorzugt formschlüssig und/oder entsprechend profilierten Gehäuse-Profilabschnitt aufweisen.

12. Vorrichtung nach einem der Ansprüche 1 bis 11, **dadurch gekennzeichnet, dass** die Stößeleinheit zumindest abschnittsweise magnetisch leitend ausgeführt und durch magnetische Lagermittel im zugeordneten Gehäuseabschnitt geführt ist.

## Claims

1. An actuator device with
an expansion unit (10; 10a to 10d), having a magnetic shape memory alloy material (MSM), designed so as to interact with a preferably non-magnetic plunger unit (16; 16a to 16d), and executing an expansion movement along a positioning direction as a reaction to an introduced magnetic flux,
which expansion unit is aligned with a longitudinal axis determined by the expansion direction onto the plunger unit, and is provided for purposes of exerting a positioning force onto the latter,
wherein the plunger unit is guided on the inner surface of an associated housing section (21) of the actuator unit,
**characterised in that**,
an end section (11a to 11d) of the expansion unit implemented in a transition region between the expansion unit and the plunger unit, and/or an end section (17a to 17d) of the plunger unit, is designed such that at least in the event of the exertion of the positioning force along the longitudinal axis an overlap occurs in the transition region causing a shape fit and/or a force fit transverse to the longitudinal axis.

2. The device according to claim 1, **characterised in that**, the end section of the expansion unit is designed as a tapering wedge or cone, or is curved in a concave form, or in the form of a shallow dome, or calotte, and is designed so as to interact with the end section of the plunger unit, having an inner cone with the form of a wedge, funnel, dome, or calotte, in particular a spherical calotte.

3. The device according to claim 1 or 2, **characterised in that**, in the transition region a tongue-and-groove joint and/or a form-fit joint is implemented between the expansion unit and the plunger unit, which provides for one of the joining partners in particular a conical, conical section or cylindrical projection, and for the other joining partner a correspondingly form-fit design of recess.

4. The device according to claim 3, **characterised in that**, the recess (26) is designed as an opening or a longitudinal bore, in particular in the expansion unit.

5. The device according to one of the claims 1 to 4, **characterised in that**, the transition region has a connecting element (30), implementing the overlap, on an end region of the expansion unit or the plunger unit, preferably non-detachably fixed or integrally connected with the plunger unit, which offers up to the end region of the respectively other unit an at least partially surrounding reception section (32), in particular a sleeve section.

6. The device according to claim 5, **characterised in that**, a flux-conducting section, for purposes of introducing magnetic flux into the expansion unit, provided adjacent to the latter, has in longitudinal section a shape matched to a longitudinal section contour of the connecting element and/or of the reception section, or is axially shortened by an axial extent of the connecting element or the reception section.

7. An actuator device, in particular an actuator device according to one of the claims 1 to 6, with
an expansion unit, having a magnetic shape memory alloy material (MSM), designed so as to interact with a preferably non-magnetic plunger unit and executing an expansion movement along a positioning direction as a reaction to an introduced magnetic flux, which expansion unit is aligned with a longitudinal axis determined by the expansion direction onto the plunger unit, and is provided for purposes of exerting a positioning force on the latter, wherein the plunger unit is guided on the inner surface of an associated housing section of the actuator unit,
**characterised in that**,
in a transition region between the expansion unit and the plunger unit the units are non-detachably connected with one another, in particular by means of an adhesive, brazed, or welded joint.

8. An actuator device with
an expansion unit having a magnetic shape memory alloy material (MSM), designed so as to interact with a preferably non-magnetic plunger unit and executing an expansion movement along a positioning direction as a reaction to an introduced magnetic flux,
which expansion unit is aligned with a longitudinal axis determined by the expansion direction onto the plunger unit, and is provided for purposes of exerting a positioning force on the latter,
wherein the plunger unit is guided on the inner surface of an associated housing section of the actuator unit,
**characterised in that**,
the expansion unit, held in an MSM housing section of the actuator device, on the inner surface, and/or on an end face located axially opposite to a transition region to the plunger unit, has supporting and/or aligning agents (28; 34; 36) assigned such that, in particular in the event of the exertion of the positioning force by the expansion unit, a moment is exerted aligning the latter with the longitudinal axis.

9. The device according to claim 8, **characterised in that**, the supporting and/or aligning agents have cushioning, flexing and/or spring means engaging with the inner surface of the expansion unit and providing support distancing the latter from a surrounding housing section.

10. The device according to claim 9, **characterised in that**, the cushioning, flexing and/or spring means are designed so as to conduct magnetic flux, and enable the introduction of the magnetic flux from the surrounding housing section into the expansion unit.

11. The device according to one of the claims 1 to 10, **characterised in that**, the supporting and/or aligning agents have a housing profile section, interacting with the profiled design of the end face, preferably in a form fit and/or correspondingly profiled.

12. The device according to one of the claims 1 to 11, **characterised in that**, the plunger unit is embodied so as to be magnetically conducting in at least some sections, and is guided by magnetic bearing agents in the associated housing section.

## Revendications

1. Dispositif d'actionneur
comprenant une unité d'expansion (10 ; 10a à 10d) présentant un matériau magnétique en alliage à mémoire de forme (MSM), réalisée pour coopérer avec une unité de poussoir (16 ; 16a à 16d) de préférence non magnétique et effectuant un mouvement d'expansion le long d'une direction de réglage en réaction à un flux magnétique introduit,
qui est orientée vers l'unité de poussoir le long d'un axe longitudinal défini par la direction d'expansion et qui est prévue pour exercer une force de réglage sur celle-ci,
l'unité de poussoir étant guidée du côté de l'enveloppe dans une portion de boîtier associée (21) de l'unité d'actionneur,
**caractérisé en ce**
**qu'**une portion d'extrémité (11a à 11d) de l'unité d'expansion, et/ou une portion d'extrémité (17a à 17d) de l'unité de poussoir réalisées dans une région de transition entre l'unité d'expansion et l'unité de poussoir, sont réalisées de telle sorte qu'au moins lors de l'application de la force de réglage le long de l'axe longitudinal dans la région de transition, il se produise un chevauchement provoquant un engagement par correspondance de forme et/ou par force transversalement à l'axe longitudinal.

2. Dispositif selon la revendication 1, **caractérisé en ce que** la portion d'extrémité de l'unité d'expansion est réalisée avec une section se rétrécissant sous forme de clavette ou de cône ou de manière cintrée sous forme concave, en forme de coupelle aplatie ou de calotte, et de manière à coopérer avec la portion d'extrémité de l'unité de poussoir présentant un cône interne, une forme de clavette, d'entonnoir, de coupelle ou de calotte, notamment une forme de calotte sphérique.

3. Dispositif selon la revendication 1 ou 2, **caractérisé en ce que** dans la région de transition est réalisée une connexion à ressort et languette et/ou une connexion par engagement par correspondance de forme entre l'unité d'expansion et l'unité de poussoir, qui prévoit, pour l'un des partenaires de connexion, une saillie notamment en forme de cône, de portion de cône ou cylindrique, et pour l'autre des partenaires de connexion, un renfoncement réalisé de manière correspondante par engagement par correspondance de forme.

4. Dispositif selon la revendication 3, **caractérisé en ce que** le renfoncement (26) est réalisé sous forme d'orifice ou d'alésage longitudinal, en particulier dans l'unité d'expansion.

5. Dispositif selon l'une quelconque des revendications 1 à 4, **caractérisé en ce que** la région de transition présente un élément de connexion (30) réalisant le chevauchement, fixé de préférence de manière inamovible à la région d'extrémité de l'unité d'expansion ou de l'unité de poussoir, ou connecté d'une seule pièce à l'unité de poussoir, qui offre une portion de réception (32), en particulier une portion de douille, entourant au moins en partie la région d'extrémité de l'autre unité respective.

6. Dispositif selon la revendication 5, **caractérisé en ce qu'**une portion de guidage du flux prévue pour introduire le flux magnétique dans l'unité d'expansion, à proximité de celle-ci, présente en coupe longitudinale une forme adaptée à un contour en coupe longitudinale de l'élément de connexion et/ou de la portion de réception ou est raccourcie axialement d'une étendue axiale de l'élément de connexion ou de la portion de réception.

7. Dispositif d'actionneur, en particulier dispositif d'actionneur selon l'une quelconque des revendications 1 à 6,
comprenant une unité d'expansion présentant un matériau magnétique en alliage à mémoire de forme (MSM), réalisée pour coopérer avec une unité de poussoir de préférence non magnétique et effectuant un mouvement d'expansion le long d'une direction de réglage en réaction à un flux magnétique introduit, qui est orientée vers l'unité de poussoir le long d'un axe longitudinal défini par la direction d'expansion et qui est prévue pour exercer une force de réglage sur celle-ci, l'unité de poussoir étant guidée du côté de l'enveloppe dans une portion de boîtier associée du dispositif d'actionneur,
**caractérisé en ce que**
dans une région de transition entre l'unité d'expansion et l'unité de poussoir, les unités sont connectées l'une à l'autre de manière inamovible, en particulier par une connexion collée, brasée ou soudée.

8. Dispositif d'actionneur comprenant
une unité d'expansion présentant un matériau magnétique en alliage à mémoire de forme (MSM), réalisée pour coopérer avec une unité de poussoir de préférence non magnétique et effectuant un mouvement d'expansion le long d'une direction de réglage en réaction à un flux magnétique introduit, qui est orientée vers l'unité de poussoir le long d'un axe longitudinal défini par la direction de réglage et qui est prévue pour exercer une force de réglage sur celle-ci, l'unité de poussoir étant guidée du côté de l'enveloppe dans une portion de boîtier associée du dispositif d'actionneur,
**caractérisé en ce que**
l'unité d'expansion retenue dans une portion de boîtier en MSM du dispositif d'actionneur, présente du côté de l'enveloppe et/ou au niveau d'un côté frontal opposé axialement à une région de transition à l'unité de poussoir des moyens de support et/ou de redressement (28 ; 34 ; 36) associés de telle sorte que notamment lors de l'application de la force de réglage, un couple de redressement soit exercé sur ceux-ci par l'unité d'expansion dans l'axe longitudinal.

9. Dispositif selon la revendication 8, **caractérisé en ce que** les moyens de support ou de redressement présentent des moyens tampons, de foulage et/ou de ressort venant en prise du côté de l'enveloppe avec l'unité d'expansion et supportant celle-ci par une portion de boîtier enveloppant.

10. Dispositif selon la revendication 9, **caractérisé en ce que** les moyens tampons, de foulage et/ou de ressort sont réalisés de manière à conduire le flux magnétique et permettent l'introduction du flux magnétique depuis la portion de boîtier enveloppante dans l'unité d'expansion.

11. Dispositif selon l'une quelconque des revendications 1 à 10, **caractérisé en ce que** les moyens de support et/ou de redressement présentent une portion profilée de boîtier coopérant avec le côté frontal réalisé sous forme profilée, de préférence par engagement par correspondance de forme et/ou profilée de manière correspondante.

12. Dispositif selon l'une quelconque des revendications 1 à 11, **caractérisé en ce que** l'unité de poussoir est réalisée de manière au moins en partie magnétiquement conductrice et est guidée par des moyens de palier magnétiques dans la portion de boîtier associée.
